# NEUE EUROPÄISCHE PATENTSCHRIFT

(11) **EP 1 953 829 B2**
(45) Veröffentlichungstag und Bekanntmachung des Hinweises auf die Entscheidung über den Einspruch: **23.11.2016**
(45) Hinweis auf die Patenterteilung: 02.03.2011
(21) Anmeldenummer: 08100857.5
(22) Anmeldetag: 24.01.2008
(51) Int. Cl.: B29K 105/00, B29C 65/10, B29C 65/14, B29C 65/50, B29C 65/00, B32B 37/18, B29L 29/00, H01L 31/18, B29K 31/00, B32B 37/00, B32B 17/10, B29L 9/00, H01L 31/048, B29C 35/08, B29C 65/48

(54) **Verfahren zur Herstellung von Solarmodulen im Walzenverbundverfahren**
Method for manufacturing solar modules by roll laminating method
Procédé de fabrication de modules solaires selon le procédé de lamination avec un rouleau

(30) Priorität: 01.02.2007 DE 102007005845
(43) Veröffentlichungstag der Anmeldung: 06.08.2008
(73) Patentinhaber: Kuraray Europe GmbH, 65926 Frankfurt am Main (DE)
(72) Erfinder: Koll, Bernhard, Dr., 53757, St. Augustin (DE); Karpinski, Andreas, 51519, Odenthal (DE)
(74) Vertreter: Kisters, Michael Marcus

(56) Entgegenhaltungen:
- JP-A- 2002 361 744
- US-A- 5 516 704
- US-A1- 2002 038 663
- US-A1- 2003 183 322
- US-A1- 2005 284 516

## Beschreibung

### Technisches Gebiet

Die Erfindung betrifft die Herstellung von Dünnschicht-Solarmodulen im Walzenverbundverfahren unter Verwendung einer auf Polyvinylbutyral (PVB) basierenden Folie.

### Stand der Technik

Dünnschicht-Solarmodule bestehen in der Regel aus einer photosensitiven Halbleiterschicht (im Folgenden als Solarzelleneinheit bezeichnet), die auf eine meist transparente Platte z.B. durch Aufdampfen, Gasphasenabscheidung, Sputtern oder Nassabscheidung aufgebracht ist und zum Schutz gegen äußere Einflüsse mit einer ggf. ebenfalls transparenten Abdeckung versehen werden. Die Solarzelleneinheiten werden häufig zwischen eine Glasscheibe und eine Abdeckplatte z.B. aus Glas mit Hilfe eines optional transparenten Klebers laminiert. Der Kleber muss die Solarzelleneinheiten vollständig umschließen, UV-stabil sein und nach dem Laminierprozess vollständig blasenfrei sein.

Als transparente Kleber werden häufig aushärtende Gießharze oder vernetzbare, auf Ethylenvinylacetat (EVA) basierende Systeme eingesetzt, so wie beispielsweise in JP07169986, DE 41 22 721 C1 oder DE 41 28 766 A1 offenbart. Diese Klebesysteme können im ungehärteten Zustand so niedrigviskos eingestellt werden, dass sie die Solarzelleneinheiten blasenfrei bedecken. Nach Zugabe eines Härters oder Vernetzungsmittels wird eine mechanisch widerstandfähige Klebeschicht erhalten. Nachteilig an solchen Solarmodulen ist deren aufwändige Herstellung; insbesondere bei großflächigen Fassadenelementen ist die Einbettung der Solarzelleneinheiten in das flüssige Gießharz und dessen kontrollierte Aushärtung ein schwierig zu kontrollierender Prozess. Zudem neigen einige Gießharze nach einigen Jahren zur Blasenbildung bzw. Delamination.

Eine Alternative zu aushärtenden Klebesystemen ist der Einsatz von auf Polyvinylbutyral (PVB) basierenden Folien. Hier werden die Solarzelleneinheiten mit einer oder mehreren PVB-Folien bedeckt und diese unter erhöhtem Druck und erhöhter Temperatur mit den gewünschten Abdeckmaterialien zu einem Laminat verbunden. Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2, DE 197 32 217, DE 40 26 165, US 6,160,215, WO 02/103809, US 6,660,556, US 2005/0115667 oder US 4,321,418 bekannt. In diesen Publikationen dient die PVB-Folie zur Einbettung von kristallinen Solarzelleneinheiten; einlagige Systeme für Dünnschicht-Solarmodule bzw. die hierfür geeignetes Herstellverfahren sind nicht beschrieben.

Die Verwendung von PVB-Folien in Solarmodulen als Verbundverglasungen ist z.B. in DE 20 302 045 U1, EP 1617487 A1, und DE 35 389 86 C2 offenbart. Diese Schriften beziehen sich ebenfalls auf die Verkapselung von Solarzellen zwischen zwei PVB-Folien.

Bei Dünnschicht-Solarmodulen sind die Solarzellen direkt auf einen Träger wie einer Glasscheibe oder einem flexiblen Träger aus Polymeren oder Metallen aufgebracht. Je nach Aufbau im Träger ist eine Einkapselung der Solarzellen nicht möglich. Zudem können Dünnschicht-Solarmodule in beliebiger Größe und in großen Mengen hergestellt werden. Die bekannten Verfahren zur Herstellung von Solarmodulen, die zwischen PVB-Folien eingebettete Solarzellen aufweisen, sind zur Herstellung eines Verbunds mit Dünnschicht-Solarmodulen in industriellem Maßstab nicht ausreichend automatisierbar.

Weiterhin offenbaren DE 35 38 986 C2 und DE 42 27 860 die Herstellung von Solarmodulen durch einen Laminierprozess bei erhöhter Temperatur und erhöhtem Druck. Die Verwendung eines Walzenpaares zu diesem Zweck ist nicht beschrieben.

Aus US 2002/0038663 ist bekannt, Solarmodule mittels Walzenprozess herzustellen, wobei Solarzellen mit abgerundeten Formen zur Vermeidung der Penetration der Klebefolien verwendet werden. US 7143800B2 beschreibt einen Walzenprozess zur Herstellung von Verbundglaslaminat.

### Aufgabe

Aufgabe der vorliegenden Erfindung ist es daher, ein Verfahren zur Herstellung von Dünnschicht-Solarmodulen unter Verwendung von thermoplastischen Zwischenschichtfolien bereit zu stellen, das eine kontinuierliche und/oder automatisierbare Produktion ermöglicht.

Überraschenderweise wurde gefunden, dass ein Laminierprozess mit einem Walzenpaar zur Laminierung auch von mechanisch instabilen Solarzellen geeignet ist.

### Darstellung der Erfindung

Gegenstand der vorliegenden Erfindung ist daher ein Verfahren zur Herstellung eines Solarmoduls gemäß dem 1. Anspruch, d.h. durch Laminieren eines Schichtkörpers bestehend aus einem ersten Träger, auf den mindestens eine Solarzelleneinheit aufgebracht ist und einem zweiten Träger durch mindestens eine zwischen gelegte, auf weichmacherhaltigem Polyvinylacetal basierende Folie durch Erwärmen des Schichtkörpers in mindestens einem Heiztunnel und nachfolgendes Verpressen zwischen mindestens einem Walzenpaar bei einer Temperatur von 50 bis 150 °C, insbesondere 60 bis 150 °C.

In den Presswerken werden Liniendrücke von 0,5 N/mm bis 100 N/mm, insbesondere von 10 N/mm bis 50 N/mm angelegt. Unter Liniendruck wird der Anpressdruck des Walzenpaares bezogen auf die Folienbreite verstanden.

Zur Verhinderung von Zerstörungen an den Deckplatten wird an der Vorder- und oder Hinterkante des Schichtkörpers (am Anfang und Ende des Laminates) der Liniendruck bis zum Eigengewicht der oberen Presswalzen oder durch Anheben der oberen Presswalzen bis auf Null verringert.

Zusätzlich kann es bei Störstellen im Schichtkörper wie z.B. elektrische Kontakte oder Leiterbahnen erforderlich sein, die Transportgeschwindigkeit des Schichtkörpers durch die Walzenpresse herabzusetzen, um eine erhöhte Einwirkdauer des Liniendrucks zu erreichen. Hierdurch wird eine verbesserte Entlüftung und Verklebung der Störstelle mit dem Polyvinylacetal erreicht.

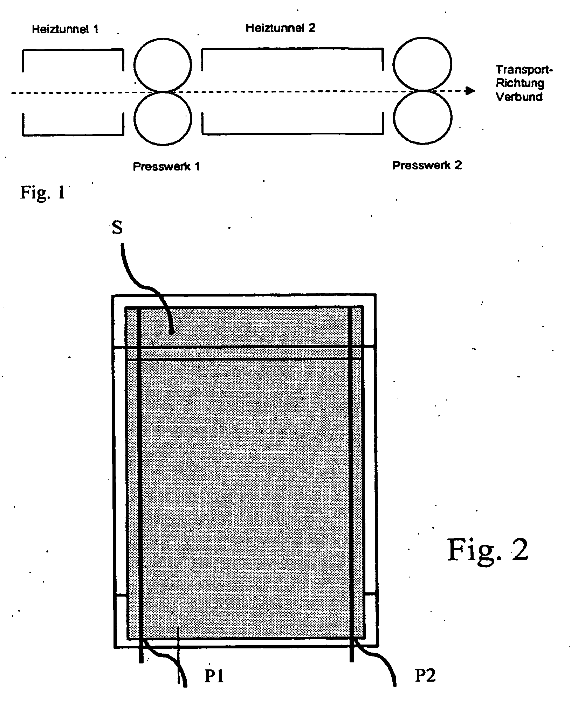

Fig. 1 zeigt den schematischen Aufbau einer geeigneten Anlage mit zwei Walzenpaaren.

Das erfindungsgemäße Verfahren wird unter Verwendung von einem oder mehreren, bevorzugt zwei Presswerken, bestehend jeweils aus einem Paar von Presswalzen durchgeführt. Hierbei wird der Schichtkörper zwischen mindestens einem Walzenpaar bei gleichem oder unterschiedlichem Liniendruck und gleicher oder unterschiedlicher Temperatur verpresst.

Anlagen dieser Art sind zur Herstellung von Verbundverglasungen bekannt und verfügen normalerweise über mindestens einen Heiztunnel zur Temperaturerhöhung oder -vergleichmäßigung vor bzw. nach dem ersten Presswerk bei Anlagen mit zwei Presswerken. Denkbar ist auch die Verarbeitung in Anlagen die über mindestens einen dem letzten Presswerk nachgelagerten Heiztunnel zur Temperaturerhöhung oder -vergleichmäßigung verfügen, oder Anlagen die mit mehr als zwei Presswerken mit jeweils vorgelagerten Heiztunneln ausgestattet sind.

Die genannten Temperaturen beziehen sich zu mindest auf den Schichtkörper vor dem letzten zu durchlaufenden Walzenpaar.

Optional ist es möglich, vor dem letzten Walzenpaar weitere Walzenpaare mit oder ohne vorgelagerte Heizzone zu schalten, wobei der Schichtkörper hier die genannten oder auch niedrigere Temperaturen als 50°C oder 60°C aufweisen kann.

Im erfindungsgemäßen werden die Schichtkörper vor dem Verpressen in Heiztunneln z.B. mit IR-, Mikrowellenstrahlung oder Konvektion auf Temperaturen von jeweils 50°C oder 60°C bis 150°C, vorzugsweise jeweils 70°C oder 80°C bis 100°C aufgeheizt. Die Temperatur der Verbunde kann z.B. berührungslos über ein Strahlungspyrometer gemessen werden.

Die auf weichmacherhaltigem Polyvinylacetal basierende Folie enthält bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben.

Es ist auch möglich, die Acetalisierung mit anderen oder weiteren Aldehyden z.B. solchen mit 5-10 Kohlenstoffatomen wie beispielsweise Valeraldehyd durchzuführen.

Die zur Herstellung der Polyvinylacetale erforderlichen Polyvinylalkohole können im Rahmen der vorliegenden Erfindung auch Terpolymere aus hydrolysierten Vinylacetat/Ethylen-Copolymeren sein. Diese Verbindungen sind in der Regel zu mehr als 98% hydrolysiert und enthalten 1 bis 10 Gew. auf Ethylen basierende Einheiten (z.B. Typ "Exceval" der Kuraray Europe GmbH). Die Acetalisierung kann wie für Polyvinylalkohol erfolgen.

Geeignete Folien auf Basis der genannten Polyvinylacetale insbesondere PVB enthalten neben 50-85 Gew.% oder 50-80 Gew.% Polyvinylacetal, 50-20 Gew.% bzw. 50-15 Gew.% Weichmacher und geringe Mengen an Haftungsregulatoren, Antiblockingmitteln und UV-Stabilisatoren. Folien dieser Art werden im Folgenden kurz als PVB-Folien bezeichnet. Die prinzipielle Herstellung und Zusammensetzung von PVB-Folien für Verbundsicherheitsverglasungen ist z. B. in EP 185 863 B1, EP 1 118 258 B1 oder WO 02/102591 A1 beschrieben.

In einer besonderen Ausführungsform der vorliegenden Erfindung besitzt das Solarmodul schalldämmende Eigenschaften, indem mindestens eine der Folien Schallschutzeigenschaften aufweist. Schallschutzfolien auf Basis von PVB sind z. B. in EP 1 118 258 B1 oder EP 387 148 B1 beschrieben. Schallschutzfolien gemäß EP 1 118 258 B1 erhöhen die Schalldämmung eines Verbundsicherheitsglases bei dessen Koinzidenzfrequenz im Bereich von 1.000 bis 3.500 Hz um mindestens 2 dB, gemessen nach DIN EN ISO 717.

Die Dicke der auf weichmacherhaltigem Polyvinylacetal basierenden Folien liegt bevorzugt bei den industriell üblichen Dicken dieser Folien wie 0.38, 0.51, 0.76, 1.14, 1.52 oder 2.28 mm.

Die auf weichmacherhaltigem Polyvinylacetal basierende Folie weist bevorzugt eine einseitig oder besonders bevorzugt beidseitig aufgebrachte Oberflächenstruktur mit einer Rauhigkeit von R_{z} > 35 µm und R_{z} < 180 µm bevorzugt R_{z} > 50 µm und R_{z} < 150 µm, besonders bevorzugt R_{z} > 70 µm und R_{z} < 130 µm und insbesondere von R_{z} > 90 µm und R_{z} < 130 µm auf. Liegt die Oberflächenrauhigkeit R_{z} unter 35 µm, kommt es bei der zum Umfließen der Leiterbahnen oder anderen Einbauten nötigen Temperatur zu einem vorzeitigen Verschließen der Ränder des Verbunds, bevor die Luft vollständig herausgepresst werden kann. Die Folge sind Lufteinschlüsse (Blasen) in der Mitte des Verbunds. Bei zu hoher Oberflächenrauhigkeit (R_{z} > 180 µm) erhöht sich die zum Abschmelzen der Rauhigkeitsspitzen benötigte Energie und der Prozess verlängert sich unakzeptabel.

Die Oberflächenstruktur der Folie kann im Extrusionsprozess durch das so genannte Fließ- oder Schmelzbruchverfahren unmittelbar vor Austritt der Kunststoffschmelze aus der Extrusionsdüse entsprechend der EP 0 185 863 B1 erzeugt werden. Unterschiedliche Rauhigkeitsniveaus können durch Variation der Austrittsspaltweite und der Düsen-Lippentemperaturen unmittelbar am Düsenaustritt gezielt erzeugt werden. Dieses Verfahren führt zu einer unregelmäßigen, annähernd isotropen Rauhigkeit. Der Messwert der Rauhigkeit ist hier über alle Richtungen gemessen annähernd gleich, wobei die einzelnen Erhebungen und Vertiefungen jedoch unregelmäßig in ihrer Höhe und Verteilung angeordnet sind.

Alternativ kann die Oberflächenstruktur der Folie durch Prägeverfahren z.B. gemäß EP 06112163 oder EP 06112159 aufgebracht werden. Hierbei ergibt sich eine regelmäßige Rauhigkeit/Rauhigkeitsstruktur der Oberfläche.

Die Messung der Oberflächenrauhigkeit R_{z} oder des Rauhigkeitswerts R_{z} erfolgt nach DIN EN ISO 4287. Die angegebenen Messungen wurden mit einem Rauhigkeitsmessgerät der Fa. Mahr Typ S2, Vorschubgerät PGK mit mechanischem Einstufentaster MFW-250 durchgeführt.

Der verpresste Körper kann anschließend einem erhöhtem oder verringertem Druck und jeweils erhöhter Temperatur ausgesetzt werden. Dies kann analog zu den bekannten Autoklaven-, Vakuumring- bzw. Vakuumsackverfahren z.B. gemäß EP 1 235 683 B1 erfolgen.

Beim Vakuumsackverfahren wird der verpresste Schichtkörper in einen Kunststoff- oder Gummisack verbracht. Anschließend wird dieser luftdicht versiegelt und mit einem Vakuumventil bevorzugt in Scheibenmitte versehen. Bei großformatigen Körpern können auch zwei Vakuumventile vorgesehen werden. Über eine Vakuumpumpe wird zunächst ein Vakuum kleiner 200 mbar aufgegeben und mindestens 5 min. bei Raumtemperatur evakuiert. Anschließend wird unter Beibehaltung des Vakuums in einem Umluftschrank das Sandwich auf 140°C aufgeheizt. Die Aufheizrate beträgt dabei je nach Heizleistung 4 bis 6 °C/min, so dass die Haltetemperatur von 140°C nach 20 bis 30 min. erreicht ist. Anschließend wird die Temperatur für 30 min. bei 140 °C gehalten. Danach muss auf min. 60°C abgekühlt werden, bevor das Vakuum entfernt werden darf. In der Praxis wird der verpresste Körper einem verringertem Druck von 0.01 bis 300 mbar und einer Temperatur von 100 bis 200 °C ausgesetzt.

Alternativ können Autoklavenprozesse eingesetzt werden. Diese sind dem Fachmann zur Herstellung von Verbundverglasungen bekannt und werden bei einem erhöhten Druck von ca. 7 bis 15 bar und Temperaturen von 130 bis 145 °C über 10 bis 120 Minuten durchgeführt.

Die erfindungsgemäß einsetzbaren Folien müssen die Solarzelleneinheiten und deren elektrischen Anschlüsse blasenfrei und kraftschlüssig bedecken bzw. einschließen; gleichzeitig ist eine möglichst geringe Gesamtdicke der Solarmodule gefordert. Hierzu ist es zweckmäßig, dass die Folien unter den Herstellungsbedingungen den Solarzelleneinheiten und deren elektrischen Anschlüssen "ausweicht", d. h. unter den Laminierbedingungen eine gewisse Fließfähigkeit aufweist.

Das Haftungsvermögen von Folien auf Basis von Polyvinylacetalen an Glas kann durch die Zugabe von Haftungsregulatoren wie z. B. die in WO 03/033583 A1 offenbarten Alkali- und/oder Erdalkalisalze von organischen Säuren eingestellt werden. Als besonders geeignet haben sich Kaliumacetat und/oder Magnesiumacetat herausgestellt. Zum Erhalt von hohen Haftungswerten kann es erforderlich sein, Folien ohne Zusatz von Haftungsregulatoren wie Alkali- und/oder Erdalkalisalze einzusetzen.

Der erste und/oder zweite Träger des erfindungsgemäßen Solarmoduls kann aus Glas, Kunststoff oder Metall oder deren Verbünde bestehen, wobei mindestens einer der Träger transparent sein muss. Es ist ebenfalls möglich, einen oder beide Träger als Verbundverglasung (d. h. als Laminat aus mindestens zwei Glasscheiben und mindestens einer Folie) oder als Isolierverglasung mit einem Gaszwischenraum auszuführen. Selbstverständlich ist auch die Kombination dieser Maßnahmen möglich.

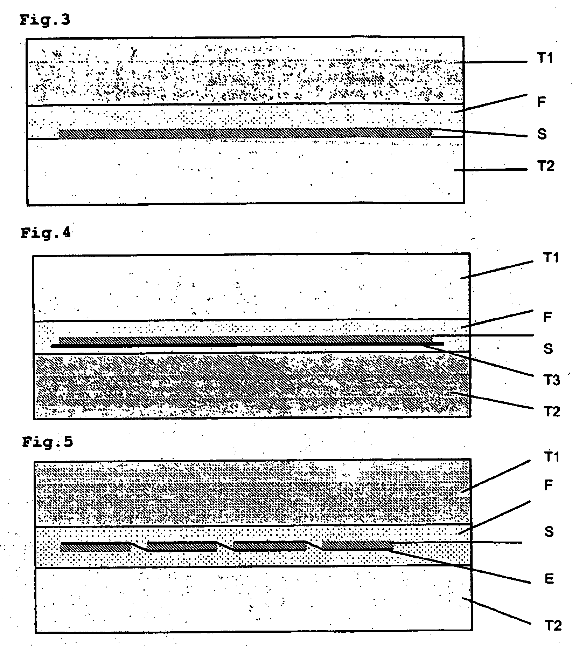

Es ist auch möglich, die Solarzelleneinheiten auf einen ersten, insbesondere einen flexiblen Träger aufzubringen und diesen zwischen zwei Schichten aus weichmacherhaltigem Polyvinylacetal und zwei, bevorzugt transparenten Trägern zu verpressen. Fig. 3 bis 5 zeigen jeweils einen schematische Aufbau von erfindungsgemäß hergestellten Laminaten, wobei T1, T2 und T3 für die Trägermaterialien, F für eine Folie oder Schicht aus weichmacherhaltigem Polyvinylacetal, S für die Solarzellen und E für die ggf. erforderliche elektrische Kontaktierung der einzelnen Solarzellen. In Fig. 3 und 4 sind die Solarzellen bzw. photoaktiven Schichten auf Trägermaterialien aufgebracht, wobei in der Variante nach Fig. 4 bevorzugt ein flexibler Träger T3 verwendet wird.

Die in den Solarmodulen eingesetzten Solarzellen müssen keine besonderen Eigenschaften besitzen. Es können kristalline oder amorphe, anorganische oder organische Halbleitersysteme eingesetzt werden, die auf den ersten Träger aufgebracht sind. Um eine ausreichende Spannung zu liefern, können mehrere Solarzellen elektrisch miteinander verbunden werden. Die Dicke der Solarzellen, bei Dünnschichtmodulen auch Funktionsschicht genannt, beträgt mindestens 0,1 µm. Die Dicke der für den elektrischen Anschluss der Solarzellen erforderlichen Leiterbahnen liegt normalerweise bei > 50 µm.

Fig. 2 zeigt einen schematischen Aufbau eines Solarmoduls, wobei S die Solarzellen und P die Leiterbahnen darstellen.

Erfindungsgemäß hergestellte Solarmodule können zusätzlich als Fassadenbauteil, Dachflächen, Wintergartenabdeckung, Schallschutzwand, Balkon- oder Brüstungselement oder als Bestandteil von Fensterflächen verwendet werden.

### Beispiel

Ein Dünnschichtmodul der Größe L 30cm x B 20cm mit einer Glasdicke 3,2mm mit zwei längs, jeweils 20mm vom Rand entfernten Leitbändern mit einer Breite von 2mm und einer Dicke von ca. 250µm wurde in einer Anlage gemäß Fig. 1 bei einer Temperatur (nach dem letzten Presswerk) von 90°C und einem Liniendruck von jeweils 35 N/mm und einer Vorschubgeschwindigkeit von 3 m/min. verpresst. Die Laufrichtung des Verbunds wurde so gewählt das der Austritt der Leiterbahnen aus dem Modul hinten lag und zuletzt verpresst wurde. Als weichmacherhaltige Polyvinylacetal-Folie wurde eine Folie des Typs Trosifol HR 100 (Kuraray Europe GmbH) mit einer Rauhigkeit R_{z} von ca. 100 µm eingesetzt.

Der Liniendruck der Presswerke wurde auf den ersten 10mm und den letzten 30mm des Schichtkörpers auf das Eigengewicht der oberen Walze reduziert.

Es wurden blasenfreie Laminate mit einer geringen Trübung erhalten.

Die Trübung konnte in einem nachfolgenden Autoklavenprozess bei 140 °C und 12 bar mit einer Haltezeit von 30 Min. vollständig beseitigt werden.

An Stelle des Autoklavenprozesses kann die Trübung auch in einem Vakuumprozess bei 145°C und 150 mbar mit einer Haltezeit von zwei Stunden beseitigt werden.

Das erfindungsgemäße Verfahren ist somit zur Herstellung von Solarmodulen geeignet, optional kann eine Trübung durch einen nachgeschalteten Verfahrensschritt beseitigt werden.

## Patentansprüche

1. Verfahren zur Herstellung eines Solarmoduls durch Laminieren eines Schichtkörpers bestehend aus einem ersten Träger, auf den mindestens eine Solarzelleneinheit aufgebracht ist und einem zweiten Träger durch mindestens eine zwischen gelegte, auf weichmacherhaltigem Polyvinylacetal basierende Folie, **gekennzeichnet durch** Erwärmen des Schichtkörpers in mindestens einem Heiztunnel und nachfolgendes Verpressen zwischen mindestens einem Walzenpaar bei einer Temperatur von 50 bis 150 °C wobei die Verpressung zwischen den Walzenpaaren bei einem Liniendruck von 0,5 N/mm bis 100 N/mm durchgeführt wird. Und der Liniendruck an der Vorderund oder Hinterkante des Schichtkörpers bis zum Eigengewicht der oberen Presswalzen oder **durch** Anheben der oberen Presswalzen bis auf Null verringert wird.

2. Verfahren zur Herstellung eines Solarmoduls nach Anspruch 1 **dadurch gekennzeichnet, dass** der Schichtkörper zwischen mindestens zwei Walzenpaaren bei gleichem oder unterschiedlichem Liniendruck und gleicher oder unterschiedlicher Temperatur verpresst wird.

3. Verfahren zur Herstellung eines Solarmoduls nach einem der Ansprüche 1 oder 2, **dadurch gekennzeichnet, dass** die auf weichmacherhaltigem Polyvinylacetal basierende Folie einen ein- oder beidseitigen Rauhigkeitswert R_{z} zwischen 35 µm und 180 µm aufweist.

4. Verfahren zur Herstellung eines Solarmoduls nach einem der Ansprüche 1 bis 3, **dadurch gekennzeichnet, dass** die auf weichmacherhaltigem Polyvinylacetal basierende Folie eine regelmäßige Rauhigkeitsstruktur aufweist.

5. Verfahren zur Herstellung eines Solarmoduls nach einem der Ansprüche 1 bis 4, **dadurch gekennzeichnet, dass** die auf weichmacherhaltigem Polyvinylacetal basierende Folie eine unregelmäßige Rauhigkeitsstruktur aufweist.

6. Verfahren zur Herstellung eines Solarmoduls nach einem der Ansprüche 1 bis 5, **dadurch gekennzeichnet, dass** der erste und/oder der zweite Träger aus Glas, Kunststoff, Metall oder deren Verbünde, einer Verbundverglasung, und/ oder einer Isolierverglasung besteht, mit der Maßgabe das mindestens einer der Träger transparent ist.

7. Verfahren zur Herstellung eines Solarmoduls nach einem der Ansprüche 1 bis 6 **dadurch gekennzeichnet, dass** der verpresste Körper einem erhöhtem oder verringertem Druck und erhöhter Temperatur ausgesetzt wird.

8. Verfahren zur Herstellung eines Solarmoduls nach Anspruch 7 **dadurch gekennzeichnet, dass** der verpresste Körper einem verringertem Druck von 0.01 bis 300 mbar und einer Temperatur von 100 bis 200 °C ausgesetzt wird.

9. Verfahren zur Herstellung eines Solarmoduls nach Anspruch 7 **dadurch gekennzeichnet, dass** der verpresste Körper einem erhöhten Druck von 7 bis 15 bar und einer Temperatur von 130 bis 145 °C ausgesetzt wird.

## Claims

1. Method for producing a solar module by laminating a layer body consisting of a first carrier, to which at least one solar cell unit is applied, and a second carrier by at least one interposed film based on a plasticiser-containing polyvinyl acetal, **characterised by** heating the layer body in at least one heating tunnel and subsequently pressing said layer body between at least one pair of rollers at a temperature of 50 to 150°C, wherein the pressing between the pair of rollers is carried out at a linear pressure of 0.5 N/mm to 100 N/mm and the linear pressure at the front edge and/or rear edge of the layer body is reduced to the inherent weight of the upper press rollers or is reduced to zero by lifting the upper press rollers.

2. Method for producing a solar module according to Claim 1, **characterised in that** the layer body is pressed between at least two pairs of rollers at the same or a different linear pressure and at the same or a different temperature.

3. Method for producing a solar module according to one of Claims 1 or 2, **characterised in that** the film based on plasticiser-containing polyvinyl acetal has a roughness value R_{z} of between 35 µm and 180 µm on one or both sides.

4. Method for producing a solar module according to one of Claims 1 to 3, **characterised in that** the film based on plasticiser-containing polyvinyl acetal has a regular roughness structure.

5. Method for producing a solar module according to one of Claims 1 to 4, **characterised in that** the film based on plasticiser-containing polyvinyl acetal has an irregular roughness structure.

6. Method for producing a solar module according to one of Claims 1 to 5, **characterised in that** the first and/or the second carrier consists of glass, plastic, metal or laminates thereof, laminated glazing and/or insulating glazing, provided that at least one of the carriers is transparent.

7. Method for producing a solar module according to one of Claims 1 to 6, **characterised in that** the pressed body is subjected to an increased or reduced pressure and increased temperature.

8. Method for producing a solar module according to Claim 7, **characterised in that** the pressed body is subjected to a reduced pressure of 0.01 to 300 mbar and a temperature of 100 to 200°C.

9. Method for producing a solar module according to Claim 7, **characterised in that** the pressed body is subjected to an increased pressure of 7 to 15 bar and a temperature of 130 to 145°C.

## Revendications

1. Procédé de fabrication d'un module solaire par laminage d'un corps stratifié, qui est constitué d'un premier support sur lequel est appliquée au moins une unité de cellules solaires et d'un deuxième support, au moyen d'au moins une feuille intercalée à base d'un poly(acétal de vinyle) contenant des plastifiants, **caractérisé en ce que** ledit corps stratifié est chauffé dans au moins un tunnel chauffant puis laminé entre au moins une paire de cylindres à une température comprise entre 50 et 150 °C, le laminage entre les paires de cylindres étant réalisé à une pression de contact comprise entre 0,5 N/mm et 100 N/mm, et que la pression de contact est réduite, au niveau de l'arête antérieure et/ou postérieure du corps stratifié, jusqu'à atteindre le poids propre des cylindres de laminage supérieurs, ou jusqu'à atteindre zéro en soulevant les cylindres de laminage supérieurs.

2. Procédé de fabrication d'un module solaire selon la revendication 1, **caractérisé en ce que** le corps stratifié est laminé entre au moins deux paires de cylindres, leurs pression de contact étant identique ou différente et leur température étant identique ou différente.

3. Procédé de fabrication d'un module solaire selon l'une des revendications 1 ou 2, **caractérisé en ce que** la feuille à base de poly(acétal de vinyle) contenant des plastifiants présente, sur l'une de ses faces ou sur les deux, une valeur de rugosité R_{z} comprise entre 35 µm et 180 µm.

4. Procédé de fabrication d'un module solaire selon l'une des revendications 1 à 3, **caractérisé en ce que** la feuille à base de poly(acétal de vinyle) contenant des plastifiants présente une structure de rugosité régulière.

5. Procédé de fabrication d'un module solaire selon l'une des revendications 1 à 4, **caractérisé en ce que** la feuille à base de poly(acétal de vinyle) contenant des plastifiants présente une structure de rugosité irrégulière.

6. Procédé de fabrication d'un module solaire selon l'une des revendications 1 à 5, **caractérisé en ce que** le premier et/ou le deuxième support est/sont constitué(s) de verre, de matière plastique, de métal ou de leurs éléments composites, d'un vitrage feuilleté et/ou d'un vitrage isolant, à condition qu'au moins un desdits supports soit transparent.

7. Procédé de fabrication d'un module solaire selon l'une des revendications 1 à 6, **caractérisé en ce que** ledit corps est exposé, suite à son laminage, à une pression élevée ou réduite et à une température élevée.

8. Procédé de fabrication d'un module solaire selon la revendication 7, **caractérisé en ce que** ledit corps est exposé, suite à son laminage, à une pression réduite comprise entre 0,01 et 300 mbar et à une température comprise entre 100 et 200 °C.

9. Procédé de fabrication d'un module solaire selon la revendication 7, **caractérisé en ce que** ledit corps est exposé, suite à son laminage, à une pression élevée comprise entre 7 et 15 bar et à une température comprise entre 130 et 145 °C.
